(19) **Europäisches Patentamt / European Patent Office / Office européen des brevets**

(11) **EP 4 668 587 A1**

(12) # EUROPEAN PATENT APPLICATION
published in accordance with Art. 153(4) EPC

(43) Date of publication:
**24.12.2025  Bulletin 2025/52**

(21) Application number: **24762953.8**

(22) Date of filing: **01.02.2024**

(51) International Patent Classification (IPC):
***H03M 7/32*** (2006.01)

(52) Cooperative Patent Classification (CPC):
**H03M 7/3002**

(86) International application number:
**PCT/CN2024/075143**

(87) International publication number:
**WO 2024/179270 (06.09.2024 Gazette 2024/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:  **02.03.2023  CN 202310237093**

(71) Applicant: **Huawei Technologies Co., Ltd.**
**Shenzhen, Guangdong 518129 (CN)**

(72) Inventors:
- **JIANG, Tianpeng**
  **Shenzhen, Guangdong 518129 (CN)**
- **SUN, Jie**
  **Shenzhen, Guangdong 518129 (CN)**
- **SUN, Zhao Yi**
  **Shenzhen, Guangdong 518129 (CN)**

- **ZHU, Tianwei**
  **Shenzhen, Guangdong 518129 (CN)**
- **MA, Dingjiong**
  **Shenzhen, Guangdong 518129 (CN)**
- **MIAO, Yun**
  **Shenzhen, Guangdong 518129 (CN)**
- **YAN, Min**
  **Shenzhen, Guangdong 518129 (CN)**
- **SUN, Chumin**
  **Shenzhen, Guangdong 518129 (CN)**
- **ZHOU, Li**
  **Shenzhen, Guangdong 518129 (CN)**
- **LI, Zhaoxing**
  **Shenzhen, Guangdong 518129 (CN)**

(74) Representative: **Gill Jennings & Every LLP**
**The Broadgate Tower**
**20 Primrose Street**
**London EC2A 2ES (GB)**

(54) ## DATA PROCESSING METHOD AND APPARATUS

(57)    This application provides a data processing method and apparatus, and relates to the field of data compression. The method includes: obtaining to-be-compressed data; sequentially performing n times of preset processing on the to-be-compressed data to obtain preprocessed data, where the preset processing includes: performing a differential operation on rows of a to-be-operated matrix, or performing a differential operation on columns of the to-be-operated matrix, where the to-be-operated matrix is a matrix obtained through a previous time of the preset processing, or the to-be-operated matrix is a matrix formed by the to-be-compressed data; and compressing the preprocessed data through entropy encoding, to obtain compressed data.

```
                                                            S101
   ┌──────────────────────────────────────────────────┐
   │         Obtain to-be-compressed data             │
   └──────────────────────────────────────────────────┘
                                                            S102
   ┌──────────────────────────────────────────────────┐
   │ Sequentially perform n times of preset processing│
   │   on the to-be-compressed data to obtain         │
   │            preprocessed data                     │
   └──────────────────────────────────────────────────┘
                                                            S103
   ┌──────────────────────────────────────────────────┐
   │ Perform entropy encoding on the preprocessed data│
   │        to obtain compressed data                 │
   └──────────────────────────────────────────────────┘
```

FIG. 3

EP 4 668 587 A1

**Description**

This application claims priority to Chinese Patent Application No. 202310237093.9, filed with the China National Intellectual Property Administration on March 2, 2023 and entitled "DATA PROCESSING METHOD AND APPARATUS", which is incorporated herein by reference in its entirety.

**TECHNICAL FIELD**

This application relates to the field of data compression, and in particular, to a data processing method and apparatus.

**BACKGROUND**

With development of information technology, a data amount of data that needs to be processed in various application scenarios experiences explosive growth, increasing difficulty in data storage, data transmission, and the like.

In a conventional technology, a corresponding data compression manner is usually used to compress a data amount, to reduce the difficulty in data storage and data transmission.

How to implement data compression more efficiently and conveniently is a problem that needs to be resolved currently.

**SUMMARY**

This application provides a data processing method and apparatus, to implement data compression more efficiently and conveniently.

According to a first aspect, a data processing method is provided. The method includes: obtaining to-be-compressed data; sequentially performing n times of preset processing on the to-be-compressed data to obtain preprocessed data, where the preset processing includes: performing a differential operation on rows of a to-be-operated matrix, or performing a differential operation on columns of the to-be-operated matrix, where the to-be-operated matrix is a matrix obtained through a previous time of the preset processing, or the to-be-operated matrix is a matrix formed by the to-be-compressed data; and compressing the preprocessed data through entropy encoding, to obtain compressed data. In the foregoing method, in the preprocessed data obtained through the n times of preset processing, rows or columns of residual data no longer have high correlation. Therefore, when entropy encoding is performed on the preprocessed data, more effective compression can be implemented on the residual data. This can implement efficient and rapid data compression effect.

In an implementation, the preset processing further includes: calculating a correlation coefficient based on two adjacent rows of data in the to-be-operated matrix, where the correlation coefficient indicates correlation between the two adjacent rows of data; and determining, based on the correlation coefficient, a value of a sign bit used when a differential operation is performed on the two adjacent rows of data; or the preset processing further includes: calculating a correlation coefficient based on two adjacent columns of data in the to-be-operated matrix, where the correlation coefficient indicates correlation between the two adjacent columns of data; and determining, based on the correlation coefficient, a value of a sign bit used when a differential operation is performed on the two adjacent columns of data. In the foregoing implementation, the correlation between the two adjacent rows of data is quantified to obtain a coefficient (referred to as the correlation coefficient) used to reflect the correlation between the two adjacent rows of data. Then, the value of the sign bit used when the differential operation is performed on the two adjacent rows of data is calculated based on the correlation coefficient.

In an implementation, the to-be-compressed data is optical fiber sensing data.

In an implementation, the to-be-compressed data is earthquake detection data.

In an implementation, the preprocessed data includes: a first field used to store the residual data, a second field used to store a sign bit used in each differential operation in the n times of preset processing, a third field used to store a number of rows of to-be-compressed data, a fourth field used to store a number of columns of the to-be-compressed data, a fifth field used to store a data dimension of the to-be-compressed data, a sixth field used to store a number of differential operations on the rows in the n times of preset processing, a seventh field used to store a number of differential operations on the columns in the n times of preset processing, an eighth field used to store version information of a compression scheme, one or more items in a ninth field indicating a data start location, and one or more items in a tenth field used to store check information.

According to a second aspect, a data processing method is provided. The method includes: obtaining compressed data; decompressing the compressed data through entropy decoding to obtain preprocessed data, where the preprocessed data includes residual data and operational information, the operational information indicates n times of preset processing sequentially performed on original data, and the preset processing includes: performing a differential operation on rows of a to-be-operated matrix, or performing a differential operation on columns of the to-be-operated matrix, where the to-be-operated matrix is a matrix obtained through a previous time of the preset processing, or the to-be-operated matrix is a matrix formed by the original data; and performing, based on the operational information, n times of inverse processing of the preset processing on the residual data, to obtain the original data.

In an implementation, the original data is optical fiber sensing data.

In an implementation, the original data is earthquake detection data.

In an implementation, the preprocessed data includes: a first field used to store the residual data, a second field used to store a sign bit used in each differential operation in the n times of preset processing, a third field used to store a number of rows of to-be-compressed data, a fourth field used to store a number of columns of the to-be-compressed data, a fifth field used to store a data dimension of the to-be-compressed data, a sixth field used to store a number of differential operations on the rows in the n times of preset processing, a seventh field used to store a number of differential operations on the columns in the n times of preset processing, an eighth field used to store version information of a compression scheme, one or more items in a ninth field indicating a data start location, and one or more items in a tenth field used to store check information.

According to a third aspect, a data processing apparatus is provided. The apparatus includes: an obtaining unit, configured to obtain to-be-compressed data; a differential unit, configured to sequentially perform n times of preset processing on the to-be-compressed data to obtain preprocessed data, where the preset processing includes: performing a differential operation on rows of a to-be-operated matrix, or performing a differential operation on columns of the to-be-operated matrix, where the to-be-operated matrix is a matrix obtained through a previous time of the preset processing, or the to-be-operated matrix is a matrix formed by the to-be-compressed data; and an entropy encoding unit, configured to compress the preprocessed data through entropy encoding, to obtain compressed data.

In an implementation, the preset processing further includes: calculating a correlation coefficient based on two adjacent rows of data in the to-be-operated matrix, where the correlation coefficient indicates correlation between the two adjacent rows of data; and determining, based on the correlation coefficient, a value of a sign bit used when a differential operation is performed on the two adjacent rows of data; or the preset processing further includes: calculating a correlation coefficient based on two adjacent columns of data in the to-be-operated matrix, where the correlation coefficient indicates correlation between the two adjacent columns of data; and determining, based on the correlation coefficient, a value of a sign bit used when a differential operation is performed on the two adjacent columns of data.

In an implementation, the to-be-compressed data is optical fiber sensing data.

In an implementation, the to-be-compressed data is earthquake detection data.

In an implementation, the preprocessed data includes: a first field used to store the residual data, a second field used to store a sign bit used in each differential operation in the n times of preset processing, a third field used to store a number of rows of to-be-compressed data, a fourth field used to store a number of columns of the to-be-compressed data, a fifth field used to store a data dimension of the to-be-compressed data, a sixth field used to store a number of differential operations on the rows in the n times of preset processing, a seventh field used to store a number of differential operations on the columns in the n times of preset processing, an eighth field used to store version information of a compression scheme, one or more items in a ninth field indicating a data start location, and one or more items in a tenth field used to store check information.

According to a fourth aspect, a data processing apparatus is provided. The apparatus includes: an obtaining unit, configured to obtain compressed data; an entropy decoding unit, configured to decompress the compressed data through entropy decoding to obtain preprocessed data, where the preprocessed data includes residual data and operational information, the operational information indicates n times of preset processing sequentially performed on original data, and the preset processing includes: performing a differential operation on rows of a to-be-operated matrix, or performing a differential operation on columns of the to-be-operated matrix, where the to-be-operated matrix is a matrix obtained through a previous time of the preset processing, or the to-be-operated matrix is a matrix formed by the original data; and a differential unit, configured to perform, based on the operational information, n times of inverse processing of the preset processing on the residual data, to obtain the original data.

In an implementation, the original data is optical fiber sensing data.

In an implementation, the original data is earthquake detection data.

In an implementation, the preprocessed data includes: a first field used to store the residual data, a second field used to store a sign bit used in each differential operation in the n times of preset processing, a third field used to store a number of rows of to-be-compressed data, a fourth field used to store a number of columns of the to-be-compressed data, a fifth field used to store a data dimension of the to-be-compressed data, a sixth field used to store a number of differential operations on the rows in the n times of preset processing, a seventh field used to store a number of differential operations on the columns in the n times of preset processing, an eighth field used to store version information of a compression scheme, one or more items in a ninth field indicating a data start location, and one or more items in a tenth field used to store check information.

According to a fifth aspect, a data processing apparatus is provided. The apparatus includes: a processor and an interface circuit. The processor receives or sends data through the interface circuit, and is configured to implement the method according to the first aspect, any one of the implementations of the first aspect, the second aspect, or any one of the implementations of the second aspect through a logic circuit or by executing code instructions.

According to a sixth aspect, a computer-readable storage medium is provided. The storage medium stores a computer program, and when the computer program is executed by a processor, the method according to the first aspect, any one of the implementations of the first aspect, the second aspect, or any one of the implementations of the second aspect is implemented.

According to a seventh aspect, a computer program product is provided. The computer program product includes instructions, and when the instructions are run on a processor, the method according to the first aspect, any one of the implementations of the first aspect, the second aspect, or any one of the implementations of the second aspect is implemented.

BRIEF DESCRIPTION OF DRAWINGS

FIG. 1 is a diagram of optical fiber sensing data according to an embodiment of this application;
FIG. 2 is a diagram of a structure of a neural network according to an embodiment of this application;
FIG. 3 is a schematic flowchart 1 of a data processing method according to an embodiment of this application;
FIG. 4 is a diagram of a structure of an information system according to an embodiment of this application;
FIG. 5 is a schematic flowchart 2 of a data processing method according to an embodiment of this application;
FIG. 6 is a schematic flowchart 3 of a data processing method according to an embodiment of this application;
FIG. 7 is a diagram 1 of a frame structure according to an embodiment of this application;
FIG. 8 is a diagram 2 of a frame structure according to an embodiment of this application;
FIG. 9 is a diagram 1 of data distribution according to an embodiment of this application;
FIG. 10 is a diagram 2 of data distribution according to an embodiment of this application;
FIG. 11 is a schematic flowchart 4 of a data processing method according to an embodiment of this application;
FIG. 12 is a diagram 1 of a structure of a data processing apparatus according to an embodiment of this application;
FIG. 13 is a diagram 2 of a structure of a data processing apparatus according to an embodiment of this application; and
FIG. 14 is a diagram 3 of a structure of a data processing apparatus according to an embodiment of this application.

**DESCRIPTION OF EMBODIMENTS**

The following describes the technical solutions in the embodiments with reference to the accompanying drawings in the embodiments. To clearly describe the technical solutions in embodiments, terms such as "first" and "second" are used in embodiments of this application to distinguish between same or similar items that have basically same functions or purposes. A person skilled in the art may understand that the terms such as "first" and "second" do not limit a number or an execution sequence, and the terms such as "first" and "second" do not indicate a definite difference. In addition, in embodiments, terms such as "example" or "for example" represent giving an example, an illustration, or a description. Any embodiment or design described as an "example" or "for example" in embodiments should not be construed as being more preferred or having more advantages than other embodiments or designs. Exactly, use of the terms such as "example" or "for example" is intended to present a related concept in a specific manner for ease of understanding.

To facilitate understanding of the technical solutions provided in embodiments of this application, related technologies in embodiments of this application are first described.

1. Data compression (data compression) is a technical method for reducing a data amount to reduce storage space and improve efficiency of transmission, storage, and processing without losing useful information, or reorganizing data according to a specific algorithm to reduce redundancy and storage space of the data. Common data compression technologies include PAQ8, Zlib, Zstd, and 7-Zip.

2. Optical fiber sensing is an important technology in modern industry. The optical fiber sensing technology is highly sensitive, and gives an instant alarm when detecting a change and provides an accurate path location for an event detected on an optical fiber. Therefore, the optical fiber sensing technology is widely used in scenarios such as protection, detection, and monitoring, and is deployed in fields such as national defense, military, aerospace, industrial control, and healthcare.

Optical fiber sensing data usually has a high collection frequency and a wide range, and there is a large amount of background noise in normal distribution. Specifically, optical fiber sensing data in osd format is used as an example. The optical fiber sensing data may include four parts: a real part of x-axis polarization, an imaginary part of x-axis polarization, a real part of y-axis polarization, and an imaginary part of y-axis polarization. Any one of the four parts includes collected data.

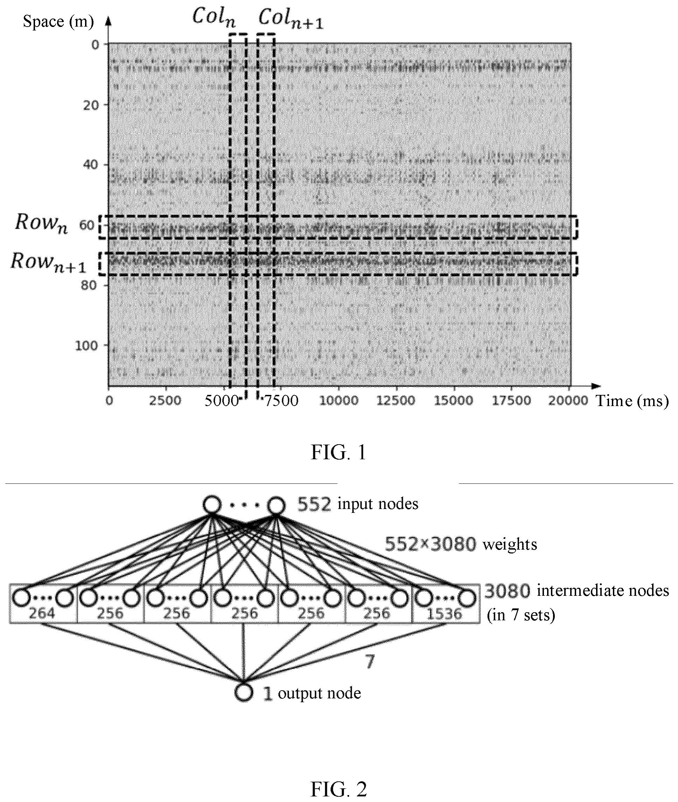

For example, optical fiber sensing data is collected by using an optical fiber with a length of 120 meters. When every 1 meter is used as a sampling point and sampling is performed every 1 millisecond, optical fiber sensing data obtained through continuous collection of 20000 milliseconds is shown in FIG. 1. As described above, the optical fiber sensing data may include four parts: a real part of x-axis polarization, an imaginary part of x-axis polarization, a real part of y-axis polarization, and an imaginary part of y-axis polarization. FIG. 1 shows data of only one of the four parts, and data of the other three parts may also be indicated in a manner similar to that in FIG. 1. The following mainly uses the data shown in FIG. 1 as an example for description, and similar processing may be performed on the data of the other three parts, repeated content is not described in this embodiment of this application.

It may be understood that, the technical solutions provided in embodiments of this application are mainly described by using an example in which the optical fiber sensing data is obtained through continuous collection of 20000 milliseconds by using the optical fiber with the length of 120 meters when every 1 meter is used as a sampling point and sampling is performed every 1 millisecond. During actual application, optical fiber sensing data that needs to be compressed may be collected by using an optical fiber longer or shorter than 120 meters. In addition, a distance greater than 1 meter or less than 1 meter may be used as a spacing between sampling points. Furthermore, a sampling cycle used may be greater than or less than 1 millisecond, and total sampling time may be greater than or less than 20000 milliseconds. Specific values of the parameters may not be limited in embodiments of this application.

In FIG. 1, pixel values of pixels in any row indicate data collected at a sampling point at a corresponding location in continuous 20000 ms. For example, pixel values of all pixels outlined by $Row_n$ in the figure indicate data continuously collected at a sampling point in continuous 20000 ms. In addition, in FIG. 1, pixel values of pixels in any column indicate data collected at all sampling points at a same moment within 120 m. For example, pixel values of all pixels outlined by $Col_n$ in the figure indicate data collected at all sampling points at this moment. Therefore, in FIG. 1, a pixel value of any point indicates data collected at corresponding time and space. For example, a pixel value of a pixel whose vertical coordinate is 40 and horizontal coordinate is 2500 indicates data collected at a sampling point at a 40-meter location at a 2500th ms moment.

A data amount of optical fiber sensing data is usually very large, and a data amount may reach 1 GB after data is continuously collected by using an optical fiber with a length of 1 kilometer for 1 minute. Because the amount of optical fiber sensing data is huge, data sharing and storage costs are high regardless of a manner such as network transmission or hard drive replacement, severely affecting efficiency and costs of subsequent data use. Therefore, if the optical fiber sensing data can be effectively compressed, effect such as saving storage space, improving transmission efficiency, and reducing disk reading frequency can be implemented, and there is wide application space and significant commercial value.

Currently, when optical fiber sensing data is compressed according to an existing data compression algorithm, storage and compression effect is usually not good. For example, Table 1 shows compression ratios when optical fiber sensing data is compressed respectively by using four data compression algorithms: Zlib-5, Zstd-5, 7-Zip, and Zpaq. Table 2 shows compression speeds when the optical fiber sensing data is compressed respectively according to four data compression algorithms: Zlib-5, Zstd-5, 7-Zip, and Zpaq.

Table 1

| File/Compression ratio | Zlib-5 | Zstd-5 | 7-Zip | Zpaq | |
|---|---|---|---|---|---|
| noise.osd | 1.24 | 1.23 | 1.39 | 1.45 | Uncompressed/Compressed |
| event.osd | 1.14 | 1.15 | 1.23 | 1.28 | Uncompressed/Compressed |

Table 2

| File/Compression speed | Zlib-5 | Zstd-5 | 7-Zip | Zpaq | |
|---|---|---|---|---|---|
| noise.osd | 25.9 | 179 | 18 | 2 | MB/s |
| event.osd | 35.61 | 243 | 5.8 | 2.6 | MB/s |

noise.osd is a file recording background noise data collected when no event occurs. event.osd is a file recording data collected when an event occurs. It can be learned that, with event.osd used as an example, a compression ratio that can be reached by using the Zpaq with a highest compression ratio is only 1.28, and a compression rate that can be reached by using the Zpaq is only 2.6 MB/s.

To implement efficient compression of such data as optical fiber sensing data, data compression may be performed in a PAQ8 compression manner in a related technology. PAQ8 is a probabilistic prediction-based arithmetic coding compression scheme invented by Matt Mahoney. In this scheme, probability distribution of a next bit is predicted based on a plurality of empirical models, and these prediction results are mixed. As shown in FIG. 2, in this mixing manner, a neural network parameter is adaptively updated by using a sparsely connected neural network during compression. After a final prediction result is obtained, arithmetic coding is performed, by using the prediction, on a compressed bit.

When the PAQ8 is used to compress the optical fiber sensing data, in the scheme, processing is performed on a per bit basis, each bit needs to be predicted by using hundreds of models, a mixing parameter needs to be adaptively updated during mixing, calculation complexity is very high, and an operation speed is only 10 KB/s. Therefore, a compression rate of compressing the optical fiber sensing data by using the scheme is still not high enough. In addition, because the optical fiber sensing data has a high-dimensional feature, and the PAQ8 mainly has a high compression ratio for one-dimensional data, a compression ratio of compressing the optical fiber sensing data by using this scheme is not high enough.

For the foregoing case, in embodiments of this application, it is considered that in some data that may be represented as a matrix, there is a specific correlation of data in adjacent rows (or data in adjacent columns) in the matrix.

The optical fiber sensing data is used as an example. The optical fiber sensing data shown in FIG. 1 may be represented as a matrix with 120 rows × 20000 columns, where each value in the matrix indicates data collected at corresponding time and space. Data collected at adjacent sampling points is usually correlated. For example, data collected at a distance of 60 m is correlated with data collected at a distance of 61 m. Therefore, in the matrix, data in adjacent rows is usually correlated. In addition, data collected at a same sampling point at a plurality of consecutive time points is usually correlated. For example, in data collected at a sampling point at the distance of 60 m, data collected at adjacent time points is correlated. Therefore, in the matrix, data in adjacent columns is usually also correlated.

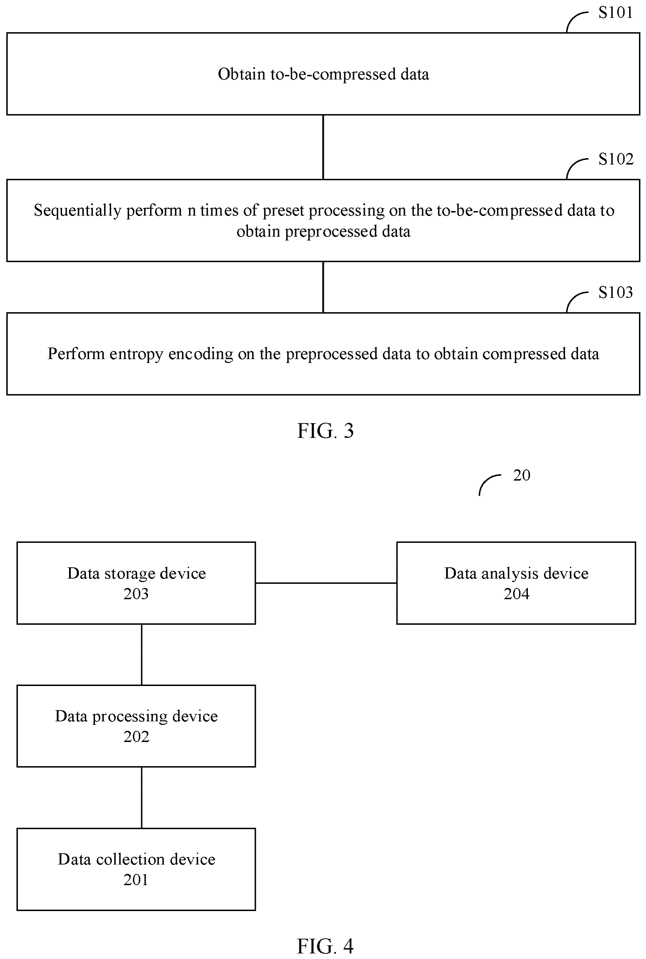

Therefore, an embodiment of this application provides a data processing method. In the method, correlation of data in adjacent rows and correlation of data in adjacent columns in to-be-compressed data are considered, and a method shown in FIG. 3 is further used to perform data compression. Specifically, in the method, after to-be-compressed data is obtained (S101), a differential operation may be first performed on rows of the to-be-compressed data, and/or a differential operation may be performed on columns of the to-be-compressed data. In addition, for a matrix output from the differential operation, a differential operation may be performed again on rows of the matrix, and/or a differential operation may be performed on columns of the matrix (for ease of description, the differential operation performed on the rows of the matrix or the differential operation performed on the columns of the matrix is collectively referred to as "preset processing"). After n times of preset processing are performed (S102), entropy encoding (S103) is performed on obtained preprocessed data (for ease of description, data obtained through the n times of preset processing is collectively referred to as "preset processing"), to obtain compressed data.

The optical fiber sensing data shown in FIG. 1 is used as an example. After the to-be-compressed data (which may be a matrix with 120 rows × 20000 columns) is obtained, a differential operation may be performed on rows of the to-be-compressed data by using an algorithm in Formula 1.

$$New R_{n+1} = R_{n+1} - S_n \times R_n \qquad \text{Formula 1}$$

$R_n$ is data in an $n^{th}$ row (namely, $Row_n$ in FIG. 1) in a matrix formed by to-be-compressed data, $R_{n+1}$ is data in an $(n+1)^{th}$ row (namely, $Row_{n+1}$ in FIG. 1) in the matrix formed by to-be-compressed data, $S_n$ is a sign bit used when a differential operation is performed on the data in the $n^{th}$ row and the $(n+1)^{th}$ row of the matrix, and $NewR_{n+1}$ is data in an $(n+1)^{th}$ row in a matrix obtained through the differential operation (the matrix obtained through the differential operation is referred to as "residual data"). A value of $S_n$ may be obtained in different manners according to an actual application requirement. For example, $S_n$ may be preset to a specific constant. For another example, $S_n$ may alternatively be calculated according to a preset algorithm. A manner of obtaining a value of $S_n$ is described in detail in S401 in the following. Details are not described herein.

A differential operation may also be performed on columns of the to-be-compressed data by using an algorithm in Formula 2.

$$New C_{n+1} = C_{n+1} - K_n \times C_n \qquad \text{Formula 2}$$

$C_n$ is data in an $n^{th}$ column (namely, $Col_n$ in FIG. 1) in a matrix formed by to-be-compressed data, $C_{n+1}$ is data in an $(n+1)^{th}$ column (namely, $Col_{n+1}$ in FIG. 1) in the matrix formed by to-be-compressed data, $K_n$ is a sign bit used when a differential operation is performed on the data in the $n^{th}$ column and the $(n+1)^{th}$ column of the matrix, and $NewC_{n+1}$ is data in an $(n+1)^{th}$ column in residual data obtained through the differential operation. For a value obtaining manner of $K_n$, refer to

an implementation process of determining $S_n$ in S401 in the following. Details are not described herein again.

In addition, after the differential operation is performed on the rows or the columns of the to-be-compressed data, a differential operation process may be repeatedly performed on a result obtained by the differential operation, to further reduce correlation of the rows or the columns of the matrix.

In the preprocessed data obtained through the n times of preset processing, rows or columns of the residual data no longer have high correlation. Therefore, when entropy encoding is performed on the preprocessed data, more effective compression can be implemented on the residual data. This can implement efficient and rapid data compression effect.

The following describes in detail data processing methods provided in embodiments of this application with reference to instances.

An application scenario of the data processing methods provided in embodiments of this application is first described. The data processing method provided in this embodiment of this application may be applied to various information systems to perform data compression. For example, FIG. 4 is a diagram of a structure of an information system according to an embodiment of this application.

For example, the information system 20 may be a security optical fiber sensing system used for intrusion detection and perimeter security detection of an oil and gas pipeline.

For another example, the information system 20 may be a seismic wave data system. In the seismic wave data system, detectors are arranged at evenly spaced locations to collect seismic wave intensity over a period of time. Through data analysis, a geological structure can be detected and imaged. This has a great application prospect in petroleum exploration, geological detection, and the like.

The information system 20 may include one or more of the following: a data collection device 201, a data processing device 202, a data storage device 203, and a data analysis device 204.

The data collection device 201 is configured to collect data. For example, the data collection device 201 may be an optical fiber device, or an earthquake monitoring device.

The data processing device 202 is configured to clean and annotate the data collected by the data collection device 201. In addition, the data processing device 202 may further perform data compression by using the data processing methods provided in embodiments of this application. Moreover, the data processing device 202 may further send compressed data to the data storage device 203 for storage.

The data storage device 203 is configured to store the data from the data storage device 203. In an implementation, the data storage device 203 may be a cloud device. In another implementation, a storage resource in the data processing device 202 may also be used to store data. In this case, the data storage device 203 may be used as a part of the data processing device 202.

The data analysis device 204 is configured to: read the data stored in the data storage device 203, decompress the data according to the data processing method provided in this embodiment of this application, and then analyze the decompressed data. The optical fiber sensing data is used as an example. The data analysis device 204 can train a feature model by using the optical fiber sensing data, to import the trained feature model into an optical fiber device (which may be the data collection device 201) for event monitoring.

During actual application, functions of the devices in the information system 20 may be implemented by electronic devices such as a personal computer (including a desktop computer, a laptop computer, a handheld computer, a notebook computer, and the like), an ultra-mobile personal computer (ultra-mobile personal computer, UMPC), a smartphone, and a server; or functions of the devices in the information system 20 may be implemented by some hardware/software apparatuses in the electronic devices. A specific form of each device in the information system 20 is not specially limited in embodiments of this application.

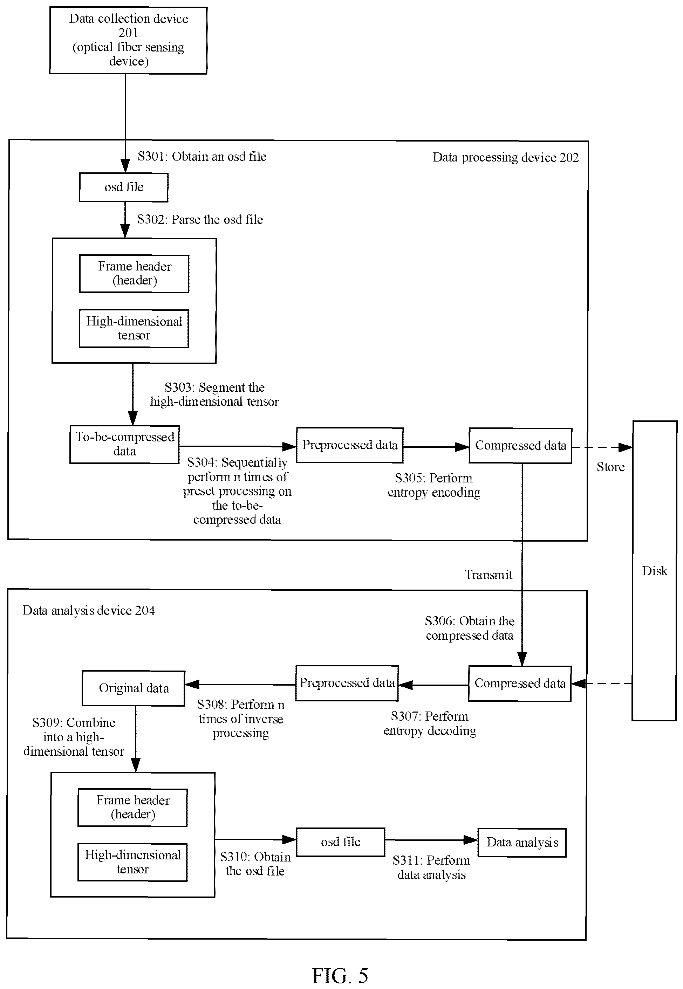

With reference to a running process of the information system 20, the following describes in detail a data processing method provided in an embodiment of this application. Specifically, an example in which the information system 20 is a security optical fiber sensing system is used. As shown in FIG. 5, the method may include the following steps.

S301: A data processing device 202 obtains an osd file.

For example, after collecting optical fiber sensing data, an optical fiber sensing device used as a data collection device 201 may package the sensing data into data in osd format (namely, an osd file), and send the data to the data processing device 202.

S302: The data processing device 202 parses the osd file.

By parsing the osd file, the data processing device 202 may obtain frame header (header) information and a high-dimensional tensor representing the optical fiber sensing data that are included in the osd file.

For example, the high-dimensional tensor may be a three-dimensional tensor. In the three-dimensional tensor, a two-dimensional matrix indicates optical fiber sensing data of each of four parts: a real part of x-axis polarization, an imaginary part of x-axis polarization, a real part of y-axis polarization, and an imaginary part of y-axis polarization.

S303: The data processing device 202 obtains to-be-compressed data.

Specifically, the data processing device 202 may segment the high-dimensional tensor into individual two-dimensional matrices through high-dimensional tensor segmentation. The to-be-compressed data may be any matrix in the two-dimensional matrices obtained through segmentation.

For example, the to-be-compressed data may be optical fiber sensing data of any one of the four parts: the real part of x-axis polarization, the imaginary part of x-axis polarization, the real part of y-axis polarization, and the imaginary part of y-axis polarization.

S304: The data processing device 202 sequentially performs n times of preset processing on the to-be-compressed data to obtain preprocessed data (for ease of description, data obtained through the n times of preset processing is referred to as "preprocessed data" in this specification).

The preset processing may include: performing a differential operation on rows of a to-be-operated matrix, or the preset processing may include: performing a differential operation on columns of the to-be-operated matrix. The to-be-operated matrix is a matrix obtained through a previous time of the preset processing, or the to-be-operated matrix is a matrix formed by the to-be-compressed data (the matrix formed by the to-be-compressed data is briefly referred to as a "to-be-compressed matrix").

To be specific, when preset processing is performed first time, a differential operation is performed on rows or columns of the to-be-compressed matrix to obtain a residual matrix (referred to as a "first residual matrix"); and then, when preset processing is performed second time, a differential operation is performed on rows or columns of the first residual matrix to obtain a second residual matrix; when preset processing is performed next time, a differential operation is performed on rows or columns of the second residual matrix to obtain a third residual matrix, until the n times of preset processing are completed.

The following describes an implementation process of performing a differential operation on the rows of the to-be-compressed matrix. It may be understood that, for a process of performing a differential operation on the columns of the to-be-compressed matrix and a preset processing process of each residual matrix, refer to the process of performing the differential operation on the rows of the to-be-compressed matrix. Repeated content is not described in this embodiment of this application.

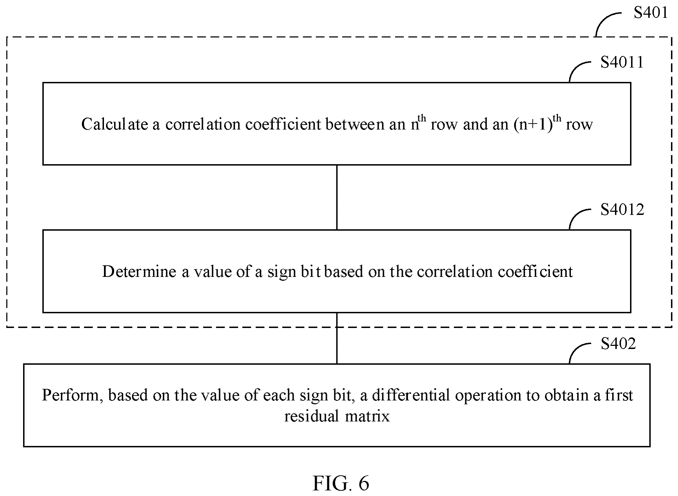

Specifically, as shown in FIG. 6, performing the differential operation on the rows of the to-be-compressed matrix includes:

S401: The data processing device 202 determines a value of a sign bit used in the differential operation.

In an implementation, correlation between two adjacent rows of data may be quantified to obtain a coefficient (referred to as a correlation coefficient) used to reflect the correlation between the two adjacent rows of data. Then, the value of the sign bit used when the differential operation is performed on the two adjacent rows of data is calculated based on the correlation coefficient. Therefore, S401 may specifically include the following steps:

S4011: The data processing device 202 calculates a correlation coefficient between an $n^{th}$ row of data $R_n$ and an $(n+1)^{th}$ row of data $R_{n+1}$ of the to-be-compressed matrix.

For example, the correlation coefficient $P_n$ between the $n^{th}$ row of data $R_n$ and the $(n+1)^{th}$ row of data $R_{n+1}$ of the to-be-compressed matrix may be expressed as:

$$\mathrm{P}_n = \frac{R_n \cdot R_{n+1}}{\|R_n\|^2} \qquad \text{Formula 3}$$

That is, a result obtained by dividing a projection length of the vector $R_{n+1}$ in a direction of the vector $R_n$ by a length of the vector $R_n$ may indicate the correlation coefficient $P_n$.

It should be noted that, during actual application, the correlation coefficient $P_n$ between the $n^{th}$ row of data $R_n$ and the $(n+1)^{th}$ row of data $R_{n+1}$ may be determined by using a calculation method other than Formula 3. A specific calculation method may not be limited in this embodiment of this application.

S4012: The data processing device 202 determines, based on the correlation coefficient $P_n$, a value $S_n$ of a sign bit used when a differential operation is performed on the $n^{th}$ row of data $R_n$ and the $(n+1)^{th}$ row of data $R_{n+1}$.

For example, the value $S_n$ of the sign bit used when the differential operation is performed on the $n^{th}$ row of data $R_n$ and the $(n+1)^{th}$ row of data $R_{n+1}$ may be expressed as:

$$S_n = floor(\mathrm{P}_n) \qquad \text{Formula 4}$$

That is, the correlation coefficient $P_n$ may be rounded to indicate the value $S_n$ of the sign bit.

It should be noted that, during actual application, the value $S_n$ of the sign bit may be determined by using a calculation method other than Formula 4. A specific calculation method may not be limited in this embodiment of this application.

S402: The data processing device 202 performs, based on the value of the sign bit used in the differential operation, the differential operation on the to-be-compressed matrix to obtain a first residual matrix.

Specifically, after determining the value $S_n$ of the sign bit used when the differential operation is performed on the $n^{th}$ row of data $R_n$ and the $(n+1)^{th}$ row of data $R_{n+1}$, the data processing device 202 may calculate data $NewR_{n+1}$ in an $(n+1)^{th}$ row of the first residual matrix according to Formula 1.

$$NewR_{n+1} = R_{n+1} - S_n \times R_n \qquad \qquad \text{Formula 1}$$

After each row of data in the first residual matrix is calculated according to the foregoing method, the first residual matrix may be obtained. The first residual matrix may be expressed as:

$$R_1, NewR_2, NewR_3, ...., NewR_N$$

N indicates a number of rows of the first residual matrix.

In addition, a sign bit corresponding to the first residual matrix may be expressed as:

$$S_1, S_2, ..., S_{N-1}$$

S401 and S402 are mainly described by using the implementation process of performing the differential operation on the rows of a to-be-compressed matrix. It may be understood that, when the differential operation is performed on the columns of the to-be-compressed matrix and preset processing (including performing a differential operation on rows or performing a differential operation on columns) is performed on each residual matrix, reference may also be made to content of S401 and S402 for implementation.

For example, when the differential operation is performed on the columns of the to-be-compressed matrix, data in an $n^{th}$ column and data in an $(n+1)^{th}$ column of the to-be-compressed matrix may be respectively used as $R_n$ and $R_{n+1}$ and substituted into Formula 3, to obtain a correlation coefficient $P_n$ indicating correlation between the data in the $n^{th}$ column and the data in the $(n+1)^{th}$ column. Then, a value $S_n$ of a sign bit used when the differential operation is performed on the data in the $n^{th}$ column and the data in the $(n+1)^{th}$ column is obtained by using Formula 4. Then, data in an $(n+1)^{th}$ column of a first residual matrix is obtained by using Formula 1.

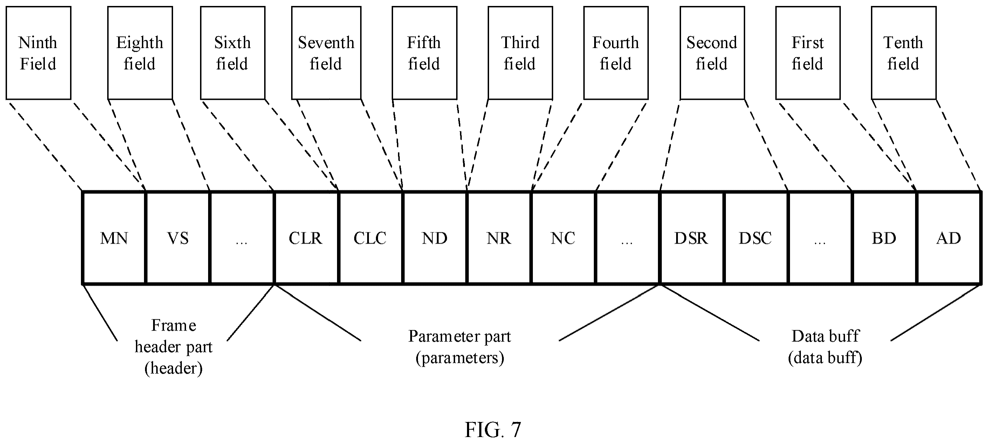

In an implementation, to facilitate encoding and decoding of preprocessed data, an embodiment of this application further provides a frame structure of the preprocessed data. As shown in FIG. 7, the preprocessed data may specifically include one or more of the following: a first field, a second field, a third field, a fourth field, a fifth field, a sixth field, a seventh field, an eighth field, a ninth field, and a tenth field.

The first field is used to store residual data obtained through the n times of preset processing. For example, in FIG. 7, the preprocessed data may include a frame header part (header), a parameter part (parameters), and a data buff part (data buff). The data buff part includes a BD field (namely, the first field) of a data subject (bulk data) used to store residual data.

The second field is used to store a sign bit used in each differential operation in n times of preset processing. For example, in FIG. 7, the data buff part includes a DSR field used to record a sign bit (a data sign of rows) when a differential operation is performed on the rows, and a DSC field used to record a sign bit (a data sign of columns) when a differential operation is performed on the columns. The DSR and the DSC are second fields.

The third field is used to record a number of rows of the to-be-compressed data. For example, in FIG. 7, the parameter part includes an NR field (namely, the third field) used to store a number of rows (number of rows). For example, during actual application, 32-bit unsigned integer (unsigned int, uint) data may be used as the NR field.

The fourth field is used to record a number of columns of the to-be-compressed data. For example, in FIG. 7, the parameter part includes an NC field (namely, the fourth field) used to store a number of columns (number of columns). For example, during actual application, 32-bit unsigned integer data may be used as the NC field.

The fifth field is used to record a dimension of the to-be-compressed data. For example, in FIG. 7, the parameter part includes an ND field (namely, the fifth field) used to store a number of dimensions (number of dimensions). For example, during actual application, 32-bit unsigned integer data may be used as the ND field.

The sixth field is used to record a number of differential operations on the rows in the n times of preset processing. For example, in FIG. 7, the parameter part includes a CLR field (namely, the sixth field) used to store a number of row compression times (compress level of row). For example, during actual application, 8-bit unsigned integer data may be used as the CLR field.

The seventh field is used to record a number of differential operations on the columns in the n times of preset processing. For example, in FIG. 7, the parameter part includes a CLC field (namely, the seventh field) used to store a number of column compression times (compress level of columns). For example, during actual application, 8-bit unsigned integer data may be used as the CLC field.

The eighth field is used to record version information of a compression scheme. For example, in FIG. 7, the frame header part includes a VS field (namely, the eighth field) used to store a version (version). For example, during actual application, 8-bit unsigned integer data may be used as the VS field.

The ninth field indicates a data start location. For example, in FIG. 7, the frame header part includes an MN field (namely, the ninth field) used to store a magic number (magic number). For example, during actual application, 16-bit unsigned integer data may be used as the MN field.

The tenth field is used to store check information. For example, in FIG. 7, the data buff part includes an AD field (namely, the tenth field) used to store Adler-32 check data (Adler-32 checksum).

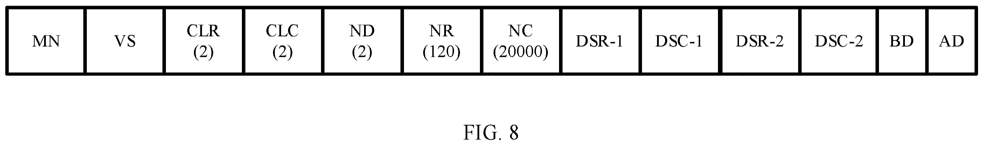

The optical fiber sensing data shown in FIG. 1 is used as an example. The to-be-compressed data is a two-dimensional matrix with 120 rows × 20000 columns. In addition, n is 4, that is, four times of preset processing is performed on the to-be-compressed data, including two differential operations on the rows and two differential operations on the columns. The four times of preset processing include one differential operation on the rows, then one differential operation on the columns, then one differential operation on the rows, and then one differential operation on the columns. Preprocessed data obtained through the four times of preset processing may be shown in FIG. 8. The CLR field is 2, indicating two differential operations on the rows. The CLC field is 2, indicating two differential operations on the columns. The ND field is 2, indicating that the to-be-compressed data is two-dimensional data. In another implementation, the ND field may alternatively indicate a number of matrices whose specification is consistent with those of to-be-compressed data (that is, 120 × 20000), included in optical fiber sensing data that includes the to-be-compressed data. For example, when the to-be-compressed data shown in FIG. 1 is only one of four parts included in the optical fiber sensing data, the ND field is 4.

The NR field is 120, indicating that there are 120 rows of to-be-compressed data. The NC field is 20000, indicating that there are 20000 columns of to-be-compressed data. In addition, the preprocessed data further includes a DSR-1 field, used to store a value of a sign bit used when a first differential operation is performed on the rows; a DSC-1 field, used to store a value of a sign bit used when a first differential operation is performed on the columns; a DSR-2 field, used to store a value of a sign bit used when a second differential operation is performed on the rows; and a DSC-2 field, used to store a value of a sign bit used when a second differential operation is performed on the columns. In addition, content of the MN, VS, BD, and AD fields may be filled based on the foregoing descriptions. Details are not described herein again.

In addition, in an implementation, in a compression process, processes of calculating the correlation coefficient (namely, S4011), calculating the value of the sign bit in the differential operation (namely, S4012), and performing the differential operation based on the value of the sign bit that are included in the process of performing preset processing on the to-be-compressed data in this embodiment of this application are all related to a lot of multiplication and addition without a serial relationship. Therefore, the method provided in this embodiment of this application may be implemented by using a single instruction multiple data (single instruction multiple data, SIMD) instruction, improving compression efficiency. Therefore, in this embodiment of this application, S304 may specifically include: sequentially performing, by using the SIMD instruction, n times of preset processing on the to-be-compressed data to obtain the preprocessed data.

In addition, in an implementation, the method provided in this embodiment of this application runs on a GPU, so that a parallel computing capability of the GPU is fully utilized, and compression efficiency can be further improved.

In addition, as shown in FIG. 5, after performing the n times of preset processing on the to-be-compressed data to obtain the preprocessed data, the method may further include:

S305: The data processing device 202 performs entropy encoding on the preprocessed data to obtain compressed data.

For example, the data processing device 202 may encode the preprocessed data by using any one of entropy encoding manners such as Shannon-Fano (Shannon-Fano) encoding, Huffman (Huffman) encoding, arithmetic coding (arithmetic coding), or run-length encoding (RLE), to obtain the compressed data.

In comparison with the to-be-compressed data, in the residual data obtained through the n times of preset processing, correlation of data is greatly reduced. Therefore, a data amount can be greatly compressed through entropy encoding. This implements efficient data compression effect.

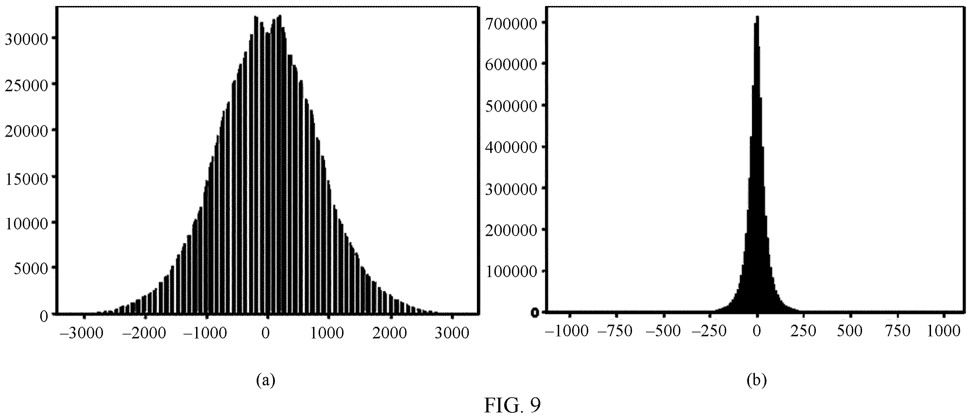

For example, when the foregoing method in this embodiment of this application is used to compress noise type data in the optical fiber sensing data, it is shown in FIG. 9. (a) in FIG. 9 shows distribution of values in the optical fiber sensing data before the n times of preset processing according to the method provided in this embodiment of this application, where a horizontal coordinate is a value, and a vertical coordinate is a number. That is, an integral result of a shadow part in (a) in FIG. 9 is a total number of values included in the optical fiber sensing data. (b) in FIG. 9 shows distribution of values in the optical fiber sensing data after the n times of preset processing according to the method provided in this embodiment of this application. It can be learned that, compared with values concentrated between -3000 and 3000 before the n times of preset processing, values are centralized between -250 and 250 after the n times of preset processing. Because types of the values are greatly reduced, when entropy encoding is performed on the optical fiber sensing data after the n times of preset processing, a data amount may be greatly compressed.

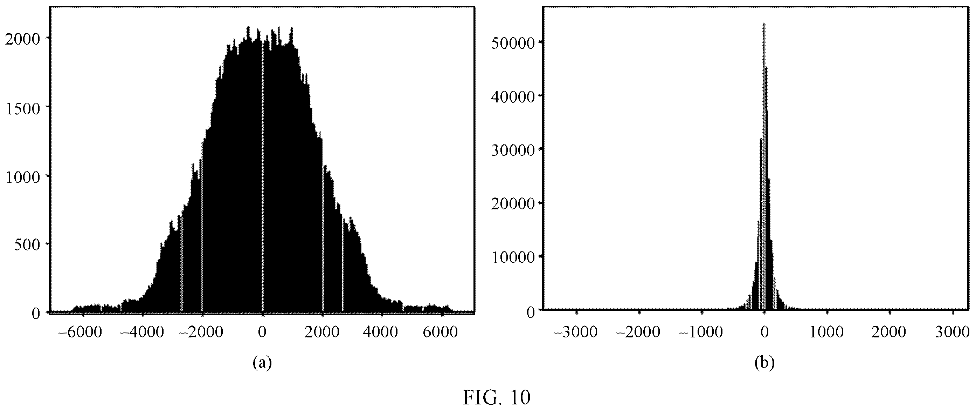

For example, when the foregoing method in this embodiment of this application is used to compress event type data in the optical fiber sensing data, it is shown in FIG. 10. (a) in FIG. 10 shows distribution of values in the optical fiber sensing data before the n times of preset processing according to the method provided in this embodiment of this application, where a horizontal coordinate is a value, and a vertical coordinate is a number. That is, an integral result of a shadow part in (a) in FIG. 10 is a total number of values included in the event type data in the optical fiber sensing data. (b) in FIG. 10 shows distribution of values in the optical fiber sensing data after the n times of preset processing according to the method provided in this embodiment of this application. It can be learned that, compared with values concentrated between -6000 and 6000 before the n times of preset processing, values are roughly centralized between -500 and 500 after the n times of preset processing. Because types of the values are greatly reduced, when entropy encoding is performed on the optical fiber sensing data after the n times of preset processing, a data amount may be greatly compressed.

In addition, after the compressed data is obtained, as shown in FIG. 5, the data processing device 202 may store the compressed data on a disk, to subsequently read the compressed data from the disk; furthermore, the data processing device 202 sends the compressed data to a data analysis device 204 (for example, the data processing device 202 may send the compressed data to a data storage device 203, and then the data storage device 203 sends the compressed data to the data analysis device 204. For another example, the data processing device 202 may directly send the compressed data to the data analysis device 204), so that the data analysis device 204 obtains and processes the compressed data.

With reference to a running process of the data analysis device 204, the following describes a data decompression process in the method provided in this embodiment of this application. Specifically, as shown in FIG. 5, the method further includes the following steps.

S306: The data analysis device 204 obtains the compressed data.

For example, the data analysis device 204 may obtain the compressed data by accessing the disk shown in FIG. 5. For another example, the data analysis device 204 may receive the compressed data from the data processing device 202.

S307: The data analysis device 204 performs entropy decoding on the compressed data to obtain preprocessed data.

Specifically, the preprocessed data includes residual data and operational information. The operational information indicates n times of preset processing sequentially performed on original data. The preset processing may include: performing a differential operation on the rows of the to-be-operated matrix, or performing a differential operation on the columns of the to-be-operated matrix. The to-be-operated matrix is a matrix obtained through a previous time of the preset processing, or the to-be-operated matrix is a matrix formed by the original data.

Specifically, the operational information may include content of all or some of the second field to the tenth field in FIG. 7.

For content and a frame structure of the preprocessed data, refer to the foregoing corresponding descriptions of FIG. 7. Repeated content is not described herein again.

S308: The data analysis device 204 performs, based on the operational information, n times of inverse processing of the preset processing on the residual data, to obtain original data.

For content included in the original data, refer to the content included in the to-be-compressed data in the foregoing descriptions. In addition, that the data analysis device 204 performs, based on the operational information, n times of inverse processing of the preset processing on the residual data may be specifically inverse processing of S303. Repeated content is not described herein again.

S309: The data analysis device 204 combines the original data into a high-dimensional tensor.

For example, the high-dimensional tensor may be a three-dimensional tensor. In the three-dimensional tensor, a two-dimensional matrix indicates optical fiber sensing data of each of four parts: a real part of x-axis polarization, an imaginary part of x-axis polarization, a real part of y-axis polarization, and an imaginary part of y-axis polarization.

S310: The data analysis device 204 combines the high-dimensional tensor into an osd file.

In this way, the data analysis device 204 may obtain the osd file obtained by the data processing device 202 in S301.

S311: The data analysis device 204 performs data analysis by using the osd file.

For example, the data analysis device 204 may train a feature model by using the osd file, to import the trained feature model into the data collection device 201 for event monitoring.

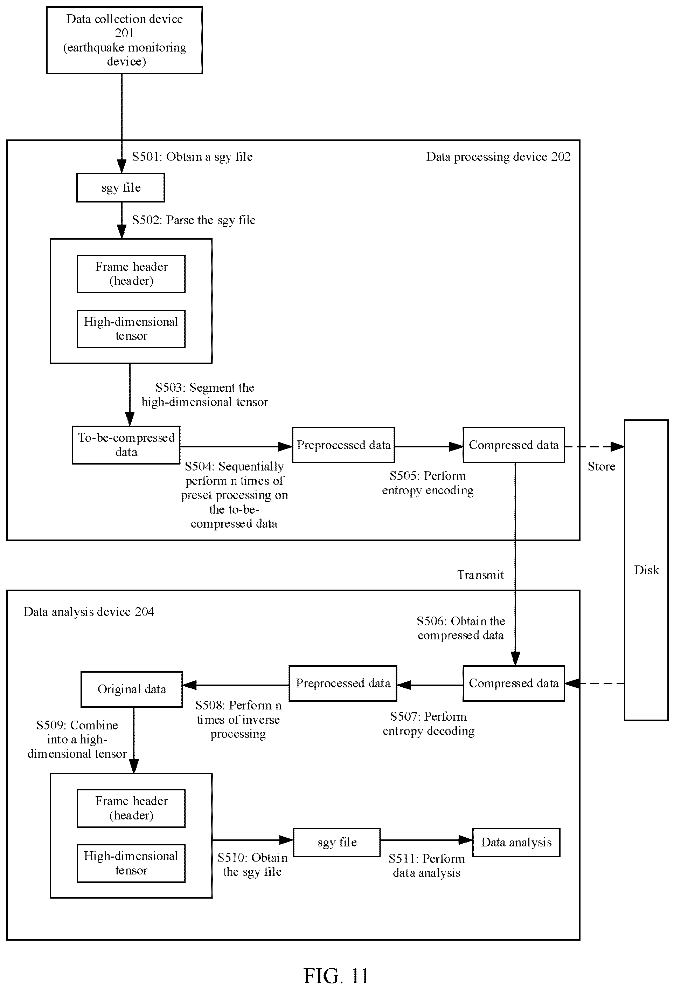

In addition, an example in which the information system 20 is a seismic wave data system is used. As shown in FIG. 11, the method may include the following steps.

S501: A data processing device 202 obtains seismic wave monitoring data.

For example, the seismic wave monitoring data may be a file in sgy format (referred to as a "sgy file").

S502: The data processing device 202 parses the sgy file.

A principle of parsing the sgy file by the data processing device 202 is similar to a principle of parsing the osd file by the data processing device 202 in S302. Therefore, for an implementation process of S502, refer to the corresponding content of S302.

S503: The data processing device 202 obtains to-be-compressed data.

Specifically, the data processing device 202 may segment a high-dimensional tensor included in the sgy file into individual two-dimensional matrices through high-dimensional tensor segmentation. The to-be-compressed data may be any matrix in the two-dimensional matrices obtained through segmentation.

For an implementation process of S503, refer to the corresponding content of S303.

S504: The data processing device 202 sequentially performs n times of preset processing on the to-be-compressed data to obtain preprocessed data (for ease of description, data obtained through the n times of preset processing is referred to as "preprocessed data" in this specification).

For an implementation process of S504, refer to the corresponding content of S304.

In addition, in an implementation, S504 in this embodiment of this application may specifically include: sequentially performing, by using an SIMD instruction, n times of preset processing on the to-be-compressed data to obtain the preprocessed data.

In addition, in an implementation, the method provided in this embodiment of this application runs on a GPU, so that a parallel computing capability of the GPU is fully utilized, and compression efficiency can be further improved.

In addition, as shown in FIG. 11, after performing the n times of preset processing on the to-be-compressed data to obtain the preprocessed data, the method may further include:

S505: The data processing device 202 performs entropy encoding on the preprocessed data to obtain compressed data.

For an implementation process of S505, refer to the corresponding content of S305.

With reference to a running process of the data analysis device 204, the following describes a data decompression process in the method provided in this embodiment of this application. Specifically, as shown in FIG. 11, the method further includes the following steps.

S506: The data analysis device 204 obtains the compressed data.

S507: The data analysis device 204 performs entropy decoding on the compressed data to obtain preprocessed data.

S508: The data analysis device 204 performs, based on the operational information, n times of inverse processing of the preset processing on the residual data, to obtain original data.

S509: The data analysis device 204 combines the original data into a high-dimensional tensor.

S510: The data analysis device 204 combines the high-dimensional tensor into a sgy file.

For an implementation process of S506 to S510, refer to the corresponding content of S306 to S310.

In addition, the method may further include:

S511: The data analysis device 204 performs data analysis by using the sgy file.

For example, the data analysis device 204 may perform tasks such as geological structure detection and imaging by using the sgy file.

With reference to FIG. 3 to FIG. 11, the foregoing describes in detail the data processing methods provided in embodiments. The following describes various apparatuses and devices corresponding to the data processing methods provided in embodiments.

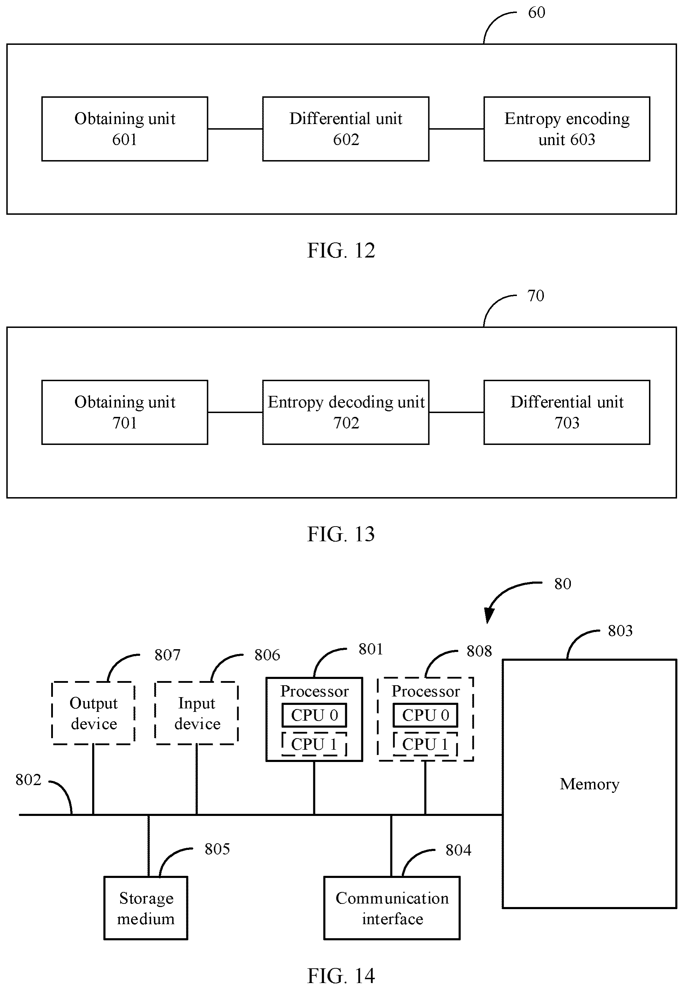

FIG. 12 is a diagram of a structure of a data processing apparatus according to an embodiment. The data processing apparatus 60 may be various devices configured to implement functions of the data processing device 202. Specifically, the data processing apparatus 60 may include a device that can perform data processing, for example, a desktop computer, a tablet computer, a desktop PC, a laptop computer, a handheld computer, a notebook computer, an ultra-mobile personal computer (ultra-mobile personal computer, UMPC), a netbook, a cellular phone, a personal digital assistant (personal digital assistant, PDA), or an augmented reality (augmented reality, AR) device/a virtual reality (virtual reality, VR) device, or the data processing apparatus 60 may be an AI hardware accelerator. The data processing apparatus 60 may be configured to perform all or some of the steps in FIG. 3, or the data processing apparatus 60 may be configured to perform all or some of the steps performed by the data processing device 202 in FIG. 5, FIG. 6, or FIG. 11. Specifically, the data processing apparatus 60 includes one or more of the following: an obtaining unit 601, a differential unit 602, and an entropy encoding unit 603.

The obtaining unit 601 is configured to obtain to-be-compressed data.

The differential unit 602 is configured to sequentially perform n times of preset processing on the to-be-compressed data to obtain preprocessed data. The preset processing may include: performing a differential operation on the rows of the to-be-operated matrix or performing a differential operation on the columns of the to-be-operated matrix. The to-be-operated matrix is a matrix obtained through a previous time of the preset processing, or the to-be-operated matrix is a matrix formed by the to-be-compressed data.

The entropy encoding unit 603 is configured to compress the preprocessed data through entropy encoding, to obtain compressed data.

In an implementation, the preset processing further includes: calculating a correlation coefficient based on two adjacent rows of data in the to-be-operated matrix, where the correlation coefficient indicates correlation between the two adjacent rows of data; and determining, based on the correlation coefficient, a value of a sign bit used when a differential operation is performed on the two adjacent rows of data; or

the preset processing further includes: calculating a correlation coefficient based on two adjacent columns of data in the to-be-operated matrix, where the correlation coefficient indicates correlation between the two adjacent columns of data; and determining, based on the correlation coefficient, a value of a sign bit used when a differential operation is performed on the two adjacent columns of data.

In an implementation, the to-be-compressed data is optical fiber sensing data.

In an implementation, the to-be-compressed data is earthquake detection data.

In an implementation, the preprocessed data includes: a first field used to store the residual data, a second field used to store a sign bit used in each differential operation in the n times of preset processing, a third field used to store a number of rows of to-be-compressed data, a fourth field used to store a number of columns of the to-be-compressed data, a fifth field used to store a data dimension of the to-be-compressed data, a sixth field used to store a number of differential operations on the rows in the n times of preset processing, a seventh field used to store a number of differential operations on the columns in the n times of preset processing, an eighth field used to store version information of a compression scheme, one or more items in a ninth field indicating a data start location, and one or more items in a tenth field used to store check information.

FIG. 13 is a diagram of a structure of another data processing apparatus according to an embodiment. The data processing apparatus 70 may be various devices configured to implement functions of the data analysis device 204. Specifically, the data processing apparatus 70 may include a device that can perform data processing, for example, a desktop computer, a tablet computer, a desktop computer, a laptop computer, a handheld computer, a notebook computer, an ultra-mobile personal computer (ultra-mobile personal computer, UMPC), a netbook, a cellular phone, a personal digital assistant (personal digital assistant, PDA), or an augmented reality (augmented reality, AR) device/a virtual reality (virtual reality, VR) device, or the data processing apparatus 70 may be an AI hardware accelerator. The data processing apparatus 70 may be configured to perform all or some of the steps performed by the data analysis device 204 in FIG. 5 or FIG. 11. Specifically, the data processing apparatus 70 includes one or more of the following: an obtaining unit 701, an entropy decoding unit 702, and a differential unit 703.

The obtaining unit 701 is configured to obtain compressed data.

The entropy decoding unit 702 is configured to decompress the compressed data through entropy decoding to obtain preprocessed data. The preprocessed data includes residual data and operational information. The operational information indicates n times of preset processing sequentially performed on original data. The preset processing may include: performing a differential operation on the rows of the to-be-operated matrix, or performing a differential operation on the columns of the to-be-operated matrix. The to-be-operated matrix is a matrix obtained through a previous time of the preset processing, or the to-be-operated matrix is a matrix formed by the original data.

The differential unit 703 is configured to perform, based on the operational information, n times of inverse processing of the preset processing on the residual data, to obtain the original data.

In an implementation, the original data is optical fiber sensing data.

In an implementation, the original data is earthquake detection data.

In an implementation, the preprocessed data includes: a first field used to store the residual data, a second field used to store a sign bit used in each differential operation in the n times of preset processing, a third field used to store a number of rows of to-be-compressed data, a fourth field used to store a number of columns of the to-be-compressed data, a fifth field used to store a data dimension of the to-be-compressed data, a sixth field used to store a number of differential operations on the rows in the n times of preset processing, a seventh field used to store a number of differential operations on the columns in the n times of preset processing, an eighth field used to store version information of a compression scheme, one or more items in a ninth field indicating a data start location, and one or more items in a tenth field used to store check information.

FIG. 14 is a diagram of a structure of another data processing apparatus according to an embodiment. The data processing apparatus 80 may be various devices configured to implement functions of the data processing device 202 or functions of the data analysis device 204. Specifically, the data processing apparatus 80 may be a chip or a system on chip. Specifically, the data processing apparatus 80 may include a device that can perform data processing, for example, a desktop computer, a tablet computer, a desktop PC, a laptop computer, a handheld computer, a notebook computer, an ultra-mobile personal computer (ultra-mobile personal computer, UMPC), a netbook, a cellular phone, a personal digital assistant (personal digital assistant, PDA), or an augmented reality (augmented reality, AR) device/a virtual reality (virtual reality, VR) device. In another implementation, the data processing apparatus 80 may alternatively be all or some software/hardware apparatuses in an AI hardware accelerator.

The data processing apparatus 80 may include some or all components of a processor 801, a communication line 802, a memory 803, and at least one communication interface 804.

The processor 801 is configured to perform all or some of the steps in the method shown in FIG. 4 in embodiments of this application, or the processor 801 is configured to perform all or some of the steps performed by the data processing device 202 in FIG. 5, FIG. 6, or FIG. 11, or the processor 801 is configured to perform all or some of the steps performed by the data analysis device 204 in FIG. 5 or FIG. 11.

Specifically, the processor 801 may include a general-purpose central processing unit (central processing unit, CPU), and the processor 801 may further include a microprocessor, a field programmable gate array (Field Programmable Gate Array, FPGA), a digital signal processor (digital signal processor, DSP), an application-specific integrated circuit (application-specific integrated circuit, ASIC), another programmable logic device, a discrete gate or a transistor logic device, a discrete hardware component, or the like.

During specific implementation, in an embodiment, the processor 801 may include one or more CPUs such as a CPU 0 and a CPU 1 shown in FIG. 14.

During specific implementation, in an embodiment, the data processing apparatus 80 may include a plurality of processors, for example, the processor 801 and a processor 808 in FIG. 14. Each of the processors may be a single-core (single-CPU) processor, or may be a multi-core (multi-CPU) processor. The processor herein may be one or more devices, circuits, and/or processing cores configured to process, for example, data (a computer program instruction).

In addition, the memory 803 may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through an example but not limitative description, many forms of RAMs may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). The memory 803 may exist independently, and be connected to the processor 801 through the communication line 802. The memory 803 may alternatively be integrated with the processor 801.

The memory 803 stores computer instructions. The processor 801 may execute the computer instructions stored in the memory 803, to perform all or some of the steps in the method shown in FIG. 4 in embodiments of this application, or perform all or some of the steps performed by the data processing device 202 in FIG. 5, FIG. 6, or FIG. 11, or perform all or some of the steps performed by the data analysis device 204 in FIG. 5 or FIG. 11.

Optionally, the computer-executable instructions in this embodiment may also be referred to as application code. This is not specifically limited in this embodiment.

In addition, the communication interface 804 is configured to communicate, by using any apparatus like a transceiver, with another device or a communication network, for example, the Ethernet, a radio access network (radio access network, RAN), or a wireless local area network (wireless local area network, WLAN).

In addition, the communication line 802 is configured to connect the components in the data processing apparatus 80. Specifically, the communication line 802 may include a data bus, a power bus, a control bus, a status signal bus, and the like. However, for clear description, various buses are all denoted as the communication line 802 in the figure.

During specific implementation, in an embodiment, the data processing apparatus 80 may further include an output device 807 and an input device 806. The output device 807 may communicate with the processor 801, and may display information in a plurality of manners. For example, the output device 807 may be a liquid crystal display (liquid crystal display, LCD), a light emitting diode (light emitting diode, LED) display device, a cathode ray tube (cathode ray tube, CRT) display device, or a projector (projector). The input device 806 may communicate with the processor 801, and may receive an input of a user in a plurality of manners. For example, the input device 806 may be a mouse, a keyboard, a touchscreen device, or a sensor device.

In addition, the data processing apparatus 80 may further include a storage medium 805. The storage medium 805 is configured to store the computer instructions and various data for implementing the technical solutions of embodiments, so that when performing the sample picture generation method in embodiments, the data processing apparatus 80 loads the computer instructions and the various data that are stored in the storage medium 805 to the memory 803, to enable the processor 801 to execute the computer instructions stored in the memory 803 to perform the data processing methods provided in embodiments.

The method steps in embodiments may be implemented in a hardware manner, or may be implemented by executing software instructions by a processor. The software instructions include corresponding software modules. The software modules may be stored in a RAM, a flash memory, a ROM, a PROM, an EPROM, an EEPROM, a register, a hard disk, a removable hard disk, a CD-ROM, or a storage medium of any other form known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located in the data processing apparatus. Certainly, the processor and the storage medium may exist in the data processing apparatus as discrete components.

All or some of the foregoing embodiments may be implemented by using software, hardware, firmware, or any combination thereof. When software is used to implement the embodiments, all or a part of the embodiments may be implemented in a form of a computer program product. The computer program product includes one or more computer programs or instructions. When the computer programs or instructions are loaded and executed on a computer, all or some of the procedures or functions in embodiments are executed. The computer may be a general-purpose computer, a dedicated computer, a computer network, a communication apparatus, user equipment, or another programmable apparatus. The computer program or instructions may be stored in a computer-readable storage medium, or may be transmitted from a computer-readable storage medium to another computer-readable storage medium. For example, the computer program or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk drive, or a magnetic tape; or may be an optical medium, for example, a digital video disc (digital video disc, DVD); or may be a semiconductor medium, for example, an SSD.

In embodiments, unless otherwise stated or there is a logic conflict, terms and/or descriptions in different implementations are consistent and may be mutually referenced, and technical features in different embodiments may be combined based on an internal logical relationship thereof, to form a new embodiment.

In embodiments, "at least one" means one or more, "a plurality of' means two or more, and other quantifiers are similar to the foregoing case. The term "and/or" describes an association relationship of associated objects, and indicates that three relationships may exist. For example, A and/or B may indicate the following three cases: Only A exists, both A and B exist, and only B exists. In addition, an element (element) appearing in a singular form with "a", "an", or "the" does not mean "one or only one" unless otherwise specified in the context, but means "one or more than one". For example, "a device" means one or more such devices. Furthermore, "at least one of (at least one of)..." means one or any combination of subsequent associated objects. For example, "at least one of A, B, and C" includes A, B, C, AB, AC, BC, or ABC. In the text descriptions of embodiments, the character "/" usually indicates that the associated objects are in an "or" relationship. In a formula of embodiments, the character "/" indicates that the associated objects are in a "division" relationship.

**Claims**

1. A data processing method, comprising:

   obtaining to-be-compressed data;
   sequentially performing n times of preset processing on the to-be-compressed data to obtain preprocessed data, wherein the preset processing comprises: performing a differential operation on rows of a to-be-operated matrix, or performing a differential operation on columns of the to-be-operated matrix, wherein the to-be-operated matrix is a matrix obtained through a previous time of the preset processing, or the to-be-operated matrix is a matrix formed by the to-be-compressed data; and
   performing entropy encoding on the preprocessed data to obtain compressed data.

2. The method according to claim 1, wherein the preset processing further comprises:

   calculating a correlation coefficient based on two adjacent rows of data in the to-be-operated matrix, wherein the correlation coefficient indicates correlation between the two adjacent rows of data; and
   determining, based on the correlation coefficient, a value of a sign bit used when a differential operation is performed on the two adjacent rows of data; or
   the preset processing further comprises:

      calculating a correlation coefficient based on two adjacent columns of data in the to-be-operated matrix, wherein the correlation coefficient indicates correlation between the two adjacent columns of data; and
      determining, based on the correlation coefficient, a value of a sign bit used when a differential operation is performed on the two adjacent columns of data.

3. The method according to claim 1 or 2, wherein the to-be-compressed data is optical fiber sensing data.

4. The method according to claim 1 or 2, wherein the to-be-compressed data is earthquake detection data.

5. The method according to any one of claims 1 to 4, wherein the preprocessed data comprises: a first field used to store residual data, a second field used to store a sign bit used in each differential operation in the n times of preset processing, a third field used to store a number of rows of the to-be-compressed data, a fourth field used to store a number of columns of the to-be-compressed data, a fifth field used to store a data dimension of the to-be-compressed data, a sixth field used to store a number of differential operations on the rows in the n times of preset processing, a seventh field used to store a number of differential operations on the columns in the n times of preset processing, an eighth field used to store version information of a compression scheme, one or more items in a ninth field indicating a data start location, and one or more items in a tenth field used to store check information.

6. A data processing method, comprising:

obtaining compressed data;

performing entropy decoding on the compressed data to obtain preprocessed data, wherein the preprocessed data comprises residual data and operational information, the operational information indicates n times of preset processing sequentially performed on original data, and the preset processing comprises: performing a differential operation on rows of a to-be-operated matrix, or performing a differential operation on columns of the to-be-operated matrix, wherein the to-be-operated matrix is a matrix obtained through a previous time of the preset processing, or the to-be-operated matrix is a matrix formed by the original data; and

performing, based on the operational information, n times of inverse processing of the preset processing on the residual data, to obtain the original data.

7. The method according to claim 6, wherein the original data is optical fiber sensing data.

8. The method according to claim 6, wherein the original data is earthquake detection data.

9. The method according to any one of claims 6 to 8, wherein the preprocessed data comprises: a first field used to store the residual data, a second field used to store a sign bit used in each differential operation in the n times of preset processing, a third field used to store a number of rows of to-be-compressed data, a fourth field used to store a number of columns of the to-be-compressed data, a fifth field used to store a data dimension of the to-be-compressed data, a sixth field used to store a number of differential operations on the rows in the n times of preset processing, a seventh field used to store a number of differential operations on the columns in the n times of preset processing, an eighth field used to store version information of a compression scheme, one or more items in a ninth field indicating a data start location, and one or more items in a tenth field used to store check information.

10. A data processing apparatus, comprising:

an obtaining unit, configured to obtain to-be-compressed data;

a differential unit, configured to sequentially perform n times of preset processing on the to-be-compressed data to obtain preprocessed data, wherein the preset processing comprises: performing a differential operation on rows of a to-be-operated matrix, or performing a differential operation on columns of the to-be-operated matrix, wherein the to-be-operated matrix is a matrix obtained through a previous time of the preset processing, or the to-be-operated matrix is a matrix formed by the to-be-compressed data; and

an entropy encoding unit, configured to compress the preprocessed data through entropy encoding, to obtain compressed data.

11. A data processing apparatus, comprising:

an obtaining unit, configured to obtain compressed data;

an entropy decoding unit, configured to decompress the compressed data through entropy decoding to obtain preprocessed data, wherein the preprocessed data comprises residual data and operational information, the operational information indicates n times of preset processing sequentially performed on original data, and the preset processing comprises: performing a differential operation on rows of a to-be-operated matrix, or performing a differential operation on columns of the to-be-operated matrix, wherein the to-be-operated matrix is a matrix obtained through a previous time of the preset processing, or the to-be-operated matrix is a matrix formed by the original data; and

a differential unit, configured to perform, based on the operational information, n times of inverse processing of the preset processing on the residual data, to obtain the original data.

12. A data processing apparatus, comprising a processor and an interface, wherein the processor receives or sends data through the interface, and the processor is configured to implement the method according to any one of claims 1 to 5, or the processor is configured to implement the method according to any one of claims 6 to 9.

13. A computer-readable storage medium, wherein the computer-readable storage medium stores instructions; and when the instructions are run on a processor, the method according to any one of claims 1 to 5 or the method according to any one of claims 6 to 9 is implemented.

14. A computer program product, wherein the computer program product comprises instructions, and when the instructions are run on a processor, the method according to any one of claims 1 to 5 or the method according to any one of claims 6 to 9 is implemented.

FIG. 1

FIG. 2

S101

Obtain to-be-compressed data

S102

Sequentially perform n times of preset processing on the to-be-compressed data to obtain preprocessed data

S103

Perform entropy encoding on the preprocessed data to obtain compressed data

FIG. 3

20

Data storage device
203

Data analysis device
204

Data processing device
202

Data collection device
201

FIG. 4

Data collection device
201
(optical fiber sensing
device)

Data processing device 202

S301: Obtain an osd file

osd file

S302: Parse the osd file

Frame header
(header)

High-dimensional
tensor

S303: Segment the
high-dimensional tensor

To-be-compressed
data

S304: Sequentially
perform n times of
preset processing on
the to-be-
compressed data

Preprocessed data

S305: Perform
entropy encoding

Compressed data

Store

Disk

Transmit

Data analysis device 204

S306: Obtain the
compressed data

Original data

S308: Perform n
times of inverse
processing

Preprocessed data

S307: Perform
entropy decoding

Compressed data

S309: Combine
into a high-
dimensional tensor

Frame header
(header)

High-dimensional
tensor

S310: Obtain
the osd file

osd file

S311: Perform
data analysis

Data analysis

FIG. 5

Calculate a correlation coefficient between an $n^{th}$ row and an $(n+1)^{th}$ row — S4011

Determine a value of a sign bit based on the correlation coefficient — S4012

— S401

Perform, based on the value of each sign bit, a differential operation to obtain a first residual matrix — S402

FIG. 6

| Ninth Field | Eighth field | Sixth field | Seventh field | Fifth field | Third field | Fourth field | Second field | First field | Tenth field |
|---|---|---|---|---|---|---|---|---|---|

| MN | VS | ... | CLR | CLC | ND | NR | NC | ... | DSR | DSC | ... | BD | AD |
|---|---|---|---|---|---|---|---|---|---|---|---|---|---|

Frame header part (header)

Parameter part (parameters)

Data buff (data buff)

FIG. 7

| MN | VS | CLR (2) | CLC (2) | ND (2) | NR (120) | NC (20000) | DSR-1 | DSC-1 | DSR-2 | DSC-2 | BD | AD |
|----|----|---------|---------|--------|----------|------------|-------|-------|-------|-------|----|----|

FIG. 8

(a)

(b)

FIG. 9

EP 4 668 587 A1

FIG. 10

Data collection device
201
(earthquake monitoring
device)

Data processing device 202

S501: Obtain a sgy file

sgy file

S502: Parse the sgy file

Frame header
(header)

High-dimensional
tensor

S503: Segment the
high-dimensional tensor

To-be-compressed
data

S504: Sequentially
perform n times of
preset processing on
the to-be-
compressed data

Preprocessed data

S505: Perform
entropy encoding

Compressed data

Store

Disk

Transmit

Data analysis device 204

S506: Obtain the
compressed data

Original data

S508: Perform n
times of inverse
processing

Preprocessed data

S507: Perform
entropy decoding

Compressed data

S509: Combine
into a high-
dimensional tensor

Frame header
(header)

High-dimensional
tensor

S510: Obtain
the sgy file

sgy file

S511: Perform
data analysis

Data analysis

FIG. 11

26

60

| Obtaining unit 601 | Differential unit 602 | Entropy encoding unit 603 |

FIG. 12

70

| Obtaining unit 701 | Entropy decoding unit 702 | Differential unit 703 |

FIG. 13

80

803

807  Output device

806  Input device

801  Processor
CPU 0
CPU 1

808  Processor
CPU 0
CPU 1

Memory

802

805  Storage medium

804  Communication interface

FIG. 14

## INTERNATIONAL SEARCH REPORT

| International application No. |
| --- |
| **PCT/CN2024/075143** |

**A. CLASSIFICATION OF SUBJECT MATTER**

H03M 7/32(2006.01)i

According to International Patent Classification (IPC) or to both national classification and IPC

**B. FIELDS SEARCHED**

Minimum documentation searched (classification system followed by classification symbols)

IPC: H03M, G06F

Documentation searched other than minimum documentation to the extent that such documents are included in the fields searched

Electronic data base consulted during the international search (name of data base and, where practicable, search terms used)

CNKI, CNTXT, USTXT, EPTXT, WOTXT, VEN, CNABS, IEEE, BING: 差, 差分, 地震, 光纤, 矩阵, 行, 列, 压缩, 系数, 相关, 相邻, 熵编码, differen+, earthquake, fiber, matrix, row, column, compression, correlation, adjacent, entropy, encod+

**C. DOCUMENTS CONSIDERED TO BE RELEVANT**

| Category* | Citation of document, with indication, where appropriate, of the relevant passages | Relevant to claim No. |
| --- | --- | --- |
| X | US 2009192711 A1 (PATHFINDER ENERGY SERVICES, INC.) 30 July 2009 (2009-07-30) abstract, claims 7 and 28, description, paragraphs [0010]-[0017], and [0041]-[0047], and figures 1-5B | 1, 3-4, 6-8, 10-14 |
| A | CN 103313046 A (ZTE CORP.) 18 September 2013 (2013-09-18) entire document | 1-14 |
| A | CN 112219210 A (HUAWEI TECHNOLOGIES CO., LTD.) 12 January 2021 (2021-01-12) entire document | 1-14 |
| A | CN 113767626 A (HUAWEI TECHNOLOGIES CO., LTD.) 07 December 2021 (2021-12-07) entire document | 1-14 |
| A | CN 106130562 A (CNPC BOHAI DRILLING ENGINEERING COMPANY LIMITED) 16 November 2016 (2016-11-16) entire document | 1-14 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **16 April 2024** | **24 April 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| PCT/CN2024/075143 |

| Patent document cited in search report | | | Publication date (day/month/year) | Patent family member(s) | | | Publication date (day/month/year) |
|---|---|---|---|---|---|---|---|
| US | 2009192711 | A1 | 30 July 2009 | US | 8024121 | B2 | 20 September 2011 |
| CN | 103313046 | A | 18 September 2013 | None | | | |
| CN | 112219210 | A | 12 January 2021 | None | | | |
| CN | 113767626 | A | 07 December 2021 | None | | | |
| CN | 106130562 | A | 16 November 2016 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310237093